# FASCICULE DE BREVET EUROPEEN

(11) **EP 3 353 502 B1**
(45) Date de publication et mention de la délivrance du brevet: **30.10.2019**
(21) Numéro de dépôt: 16785199.7
(22) Date de dépôt: 21.09.2016
(51) Int. Cl.: G01D 5/353

(54) **SYSTEME DE MESURE ET CAPTEUR DE TEMPERATURE ET/OU DE DEFORMATION PAR ANALYSE DE RETROREFLEXION BRILLOUIN.**
MESSSYSTEM UND TEMPERATUR UND/ODER FORMÄNDERUNGSSENSOR MIT BRILLOUINRÜCKREFLEXIONSANALYSE
MEASUREMENT SYSTEM AND TEMPERATURE AND/OR SHAPE CHANGE SENSOR USING BRILLOUIN BACK-REFLECTION ANALYSIS

(30) Priorité: 22.09.2015 FR 1558913
(43) Date de publication de la demande: 01.08.2018
(73) Titulaire: Institut Français des Sciences et Technologies des Transports, de l'Amenagement et des Reseaux, 77420 Champs sur Marne (FR); Centre National de la Recherche Scientifique, 75016 Paris (FR)
(72) Inventeur: KHADOUR, Aghiad, 91170 Viry Chatillon (FR); OUDAR, Jean-Louis, 92290 Chatenay Malabry (FR)
(74) Mandataire: Cabinet Beau de Loménie
(86) Numéro de dépôt international: PCT/FR2016/052393
(87) Numéro de publication internationale: WO 2017/051119

(56) Documents cités:
- US-A1- 2011 182 544
- US-A1- 2015 003 834
- KAORU SHIMIZU ET AL: "COHERENT SELF-HETERODYNE BRILLOUIN OTDR FOR MEASUREMENT OF BRILLOUIN FREQUENCY SHIFT DISTRIBUTION IN OPTICAL FIBERS", JOURNAL OF LIGHTWAVE TECHNOLOGY, IEEE SERVICE CENTER, NEW YORK, NY, US, vol. 12, no. 5, mai 1994 (1994-05), pages 730-736, XP000480094, ISSN: 0733-8724, DOI: 10.1109/50.293961
- SYAMSUNDAR DE ET AL: "Class-A dual-frequency VECSEL at telecom wavelength", OPTICS LETTERS, OPTICAL SOCIETY OF AMERICA, US, vol. 39, no. 19, octobre 2014 (2014-10), pages 5586-5589, XP001591994, ISSN: 0146-9592, DOI: 10.1364/OL.39.005586 [extrait le 2014-09-22] cité dans la demande

## Description

### DOMAINE DE L'INVENTION

L'invention concerne un système de mesure par analyse de rétroréflexion Brillouin du type comprenant un dispositif d'émission laser configuré pour émettre une onde incidente et une onde de référence, l'onde incidente présentant une fréquence incidente et l'onde de référence présentant une fréquence de référence, la fréquence de référence étant décalée de la fréquence incidente d'une valeur prédéterminée, le système étant configuré pour, lorsqu'il est connecté à au moins une première extrémité d'une fibre optique :
- projeter l'onde incidente dans ladite première extrémité de la fibre ;
- recevoir en retour, à la première extrémité de la fibre, une onde rétroréfléchie ;
- générer une onde composite combinant au moins l'onde rétroréfléchie et l'onde de référence ;
- déterminer au moins une propriété relative à la fibre par analyse d'un spectre Brillouin de l'onde composite.

La propriété relative à la fibre déterminée par analyse du spectre Brillouin de l'onde composite peut être toute propriété de la fibre dont les variations font varier (ou affectent) le spectre Brillouin de l'onde rétroréfléchie émise par la fibre. Par exemple, la température à laquelle est portée la fibre, et/ou la forme de la fibre (et donc sa déformation), sont des propriétés de la fibre dont les variations font varier (ou affectent) le spectre Brillouin de l'onde rétroréfléchie.

De manière connue en soi, l'analyse de spectre Brillouin d'une onde est un traitement ou un ensemble de traitements permettant de déterminer une information en fonction au moins des composantes fréquentielles dites 'Brillouin' présentes dans l'onde considérée.

### ARRIERE-PLAN TECHNOLOGIQUE

Depuis plusieurs années ont été développés des systèmes de mesure par analyse de rétroréflexion Brillouin par hétérodynage optique du type indiqué précédemment. Ces systèmes permettent notamment d'acquérir des informations de température et/ou de déformation relatives à des objets, notamment des objets de grandes dimensions comme par exemple des ouvrages d'art.

Dans ce cas, de manière connue en soi, un système du type présenté précédemment est utilisé relié à une fibre optique disposée dans l'objet étudié. Il permet alors de projeter une onde, dite onde incidente, dans la fibre optique. L'analyse de l'onde rétroréfléchie reçue en retour en sortie de cette fibre permet de déterminer certaines températures et/ou déformations de l'objet étudié.

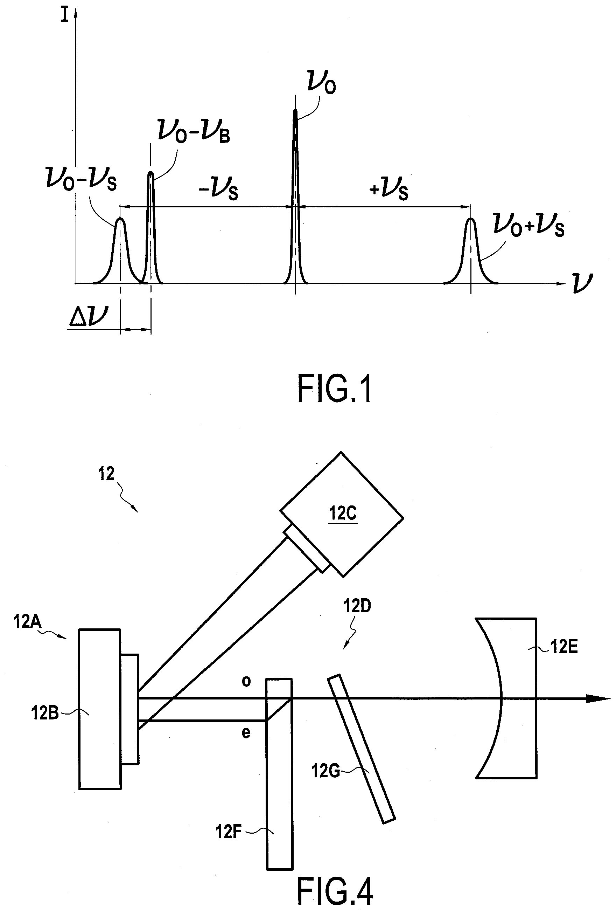

L'onde rétroréfléchie comporte, du fait de la diffusion Brillouin, des composantes fréquentielles (dites composantes fréquentielles Brillouin) décalées par rapport à la fréquence de l'onde incidente, comme le montre la figure 1 : Dans le cas où l'onde incidente est essentiellement une onde monochromatique de fréquence v0, l'onde rétroréfléchie comporte, en plus de la composante v0, au moins deux composantes fréquentielles dites Stokes et anti-Stokes, décalées respectivement d'un écart +vS et - vS par rapport à la fréquence v0 ; cet écart est appelé décalage de fréquence Brillouin.

La technique d'hétérodynage optique consiste à mélanger l'onde rétroréfléchie avec une onde de référence et à analyser la fréquence de battement obtenue entre ces deux ondes.

La fréquence v0-vB ou v0+vB de l'onde de référence (v0-vB sur la figure 1) est choisie de préférence de manière à être proche de celle de l'une ou l'autre des composantes Stokes et anti-Stokes (v0-vS ou v0+vS). Par suite, l'onde composite obtenue en combinant l'onde rétroréfléchie à l'onde de référence présente un battement dont la fréquence Δv, avantageusement, est relativement faible. Par exemple, la fréquence de battement peut se situer dans une bande de fréquences inférieure à 1 GHz.

Comme la fréquence de battement est assez faible, avantageusement elle peut être mesurée en utilisant des composants électroniques/optoélectroniques peu coûteux et simples à mettre en œuvre.

Les systèmes de mesure connus du type indiqué précédemment se classent essentiellement en deux familles.

Dans la première famille, l'onde incidente et l'onde de référence sont produites à partir d'une seule source laser. Le décalage de fréquence entre ces deux ondes est obtenu par une unité de translation de fréquence, comme par exemple un modulateur acousto-optique. Cette solution permet de réaliser l'hétérodynage optique avec une faible fréquence, mais avec une efficacité très faible, car il n'y a pas de relation de phase entre les composantes optiques qui réalisent le battement.

Dans la deuxième famille, l'onde incidente et l'onde de référence sont produites à partir de deux sources laser à rétroaction répartie, ou laser DFB (de l'anglais 'distributed feedback laser').

Un tel système est par exemple présenté par le document US2015/0003834 A1. Cependant, l'agencement proposé, avec deux lasers DFB, présente l'inconvénient de sa complexité et de son prix, liés à la présence de deux sources laser ; il présente aussi le problème que le couplage proposé pour les deux lasers DFB est lui aussi relativement complexe, coûteux, et cause des déperditions d'énergie importantes.

De plus, un tel agencement conduit à avoir des fluctuations de fréquence entre les ondes émises par les deux lasers, ainsi que des variations de l'énergie transportée par les ondes (bruit d'amplitude).

Cet agencement ne s'avère donc pas non plus très performant pour réaliser un système de mesure par analyse de rétroréflexion Brillouin.

### PRESENTATION DE L'INVENTION

L'objectif de l'invention est donc de remédier aux inconvénients des systèmes de mesure présentés précédemment, et de proposer un système de mesure permettant d'acquérir des informations par analyse de rétroréflexion Brillouin, comme des informations de température et/ou de déformation, pouvant être mis en œuvre pendant de longues périodes (jusqu'à plusieurs dizaines d'années), peu intrusif, fournissant des informations de préférence en temps réel, de coût faible, sur un ou plusieurs objets répartis éventuellement sur une grande distance (supérieure à un kilomètre, par exemple).

Cet objectif est atteint grâce à un système de mesure par analyse de rétroréflexion Brillouin du type présenté en introduction, dans lequel l'onde incidente et l'onde de référence proviennent d'une source laser bi-fréquence à cavité verticale émettant par la surface. Cette source laser fait partie naturellement du dispositif d'émission laser.

Une telle source laser peut par exemple être du type décrit par le document Class-A dual-frequency VECSEL at telecom wavelength, de MM.Syamsundar et al., Revue OPTICS LETTERS/Vol.39, No.19, October 1, 2014, pages 5586-5589.

Avantageusement, l'utilisation d'une telle source garantit la cohérence optique de l'onde incidente et de l'onde de référence.

De préférence, la source laser est une source continue.

Dans un mode de réalisation, l'onde incidente fait l'objet d'un traitement préalable entre son émission par le dispositif d'émission laser et sa projection dans la fibre optique. Ce traitement peut consister par exemple à émettre l'onde incidente sous forme d'impulsions temporelles, afin de permettre la mesure d'une position dans la fibre à laquelle l'onde rétroréfléchie est émise par réflectométrie optique en domaine temporel (OTDR, de l'Anglais 'Optical Time Domain Reflectometry').

De manière similaire, l'onde de référence peut éventuellement faire l'objet d'un traitement préalable entre son émission par le dispositif d'émission laser et sa combinaison avec l'onde rétroréfléchie.

L'invention peut être mise en œuvre dans un domaine spectral très large.

Dans un mode de réalisation préférentiel, la longueur d'onde de l'onde incidente est comprise entre 1,3 µm et 1,8 µm, et de préférence comprise entre 1,5 µm et 1,6 µm. La longueur d'onde de l'onde incidente peut notamment être de 1,55 µm. Cette longueur d'onde correspond à un décalage en fréquence de l'ordre de 11 GHz. Une longueur d'onde de 1,3 µm correspond à un décalage en fréquence de l'ordre de 12 GHz, qui est également une fréquence dans laquelle les fibres optiques présentent de bonnes caractéristiques de transmission.

Lorsque la longueur d'onde de l'onde incidente est comprise entre 1,3 µm et 1,8 µm, de préférence la valeur de l'écart de fréquence (vB) entre l'onde incidente (v0) et l'onde de référence (v0-vB) est comprise dans l'intervalle 10-12 GHz. En effet, lorsque la longueur d'onde de l'onde incidente est voisine de 1,55 µm, le décalage de fréquence Brillouin vS entre l'onde de référence v0 et les composantes Stokes v0-vS et Anti-Stokes v0+vS de l'onde rétroréfléchie est de l'ordre de 11 GHz.

Dans un mode de réalisation, le système de mesure est configuré pour permettre l'analyse de rétroréflexion en mode 'Brillouin spontané'. Dans ce mode de réalisation, l'onde rétroréfléchie est une onde rétroréfléchie dans la fibre suite à l'injection de l'onde incidente, indépendamment de toute autre onde éventuellement présente dans la fibre. On projette alors l'onde incidente à la première extrémité de la fibre et on reçoit l'onde rétroréfléchie à cette même première extrémité de la fibre.

Inversement, le système de mesure peut également être configuré pour permettre l'analyse de rétroréflexion en mode 'Brillouin stimulé'. Le système de mesure est alors configuré pour projeter également une deuxième onde à la deuxième extrémité de la fibre. La fibre optique est donc traversée par deux ondes contrapropagatives provenant de ses deux extrémités ; la rencontre de ces deux ondes fait naître une onde, dite onde rétroréfléchie, qui comporte les composantes spectrales Brillouin et est reçue à la première extrémité de la fibre (celle où l'onde incidente est injectée dans la fibre).

L'onde projetée à la deuxième extrémité de la fibre peut en particulier être l'onde de référence.

Sur le plan matériel, le système de mesure peut être agencé de différentes manières.

Pour l'acquisition de l'onde composite, l'analyse du signal transporté par celle-ci, le système de mesure peut comprendre un détecteur optique disposé sur le trajet de l'onde composite de manière à collecter l'onde composite, et un analyseur de fréquence configuré pour analyser le spectre Brillouin de l'onde composite de manière à déterminer ladite au moins une propriété relative à la fibre.

D'autre part, pour l'obtention de l'onde composite à partir de l'onde incidente et de l'onde rétroréfléchie, le système de mesure peut comprendre un premier mélangeur optique configuré pour être placé sur le trajet de l'onde incidente entre le dispositif d'émission laser et la première extrémité de la fibre optique.

Ce premier mélangeur peut être un circulateur optique ou un coupleur de fibres optiques.

Le système de mesure selon l'invention peut être mis en œuvre en mode Brillouin spontané ou en mode Brillouin stimulé.

Dans le premier cas, le système de mesure est configuré pour projeter une onde uniquement à la première extrémité de la fibre.

Dans ce cas en général, le système de mesure est configuré pour projeter une onde dans la fibre uniquement à la première extrémité de celle-ci, et comprend en outre un deuxième mélangeur optique configuré pour recevoir en entrée respectivement l'onde composite et l'onde de référence, et fournir en sortie un signal constitué en superposant ces deux ondes.

Par ailleurs, dans ce premier cas, le système de mesure peut éventuellement être mis en oeuvre sans action particulière pour modifier la polarisation de l'onde incidente émise par le dispositif d'émission laser.

Or, en sortie du dispositif d'émission laser, l'onde incidente a une polarisation linéaire, alors que l'onde rétroréfléchie quant à elle peut avoir la même polarisation ou bien une polarisation différente.

Aussi, pour améliorer la performance du système de mesure, une technique efficace consiste à agir sur la polarisation de l'onde incidente, afin d'augmenter l'amplitude des composantes fréquentielles Brillouin dans la fibre optique.

Aussi, dans un mode de réalisation préférentiel le système de mesure est configuré pour projeter une onde uniquement à la première extrémité de la fibre, et comprend en outre un contrôleur de polarisation ou un brouilleur de polarisation, interposé entre le dispositif d'émission laser et le premier mélangeur optique.

L'amplitude des composantes fréquentielles Brillouin spontanées dans la fibre optique varie suivant l'état de la biréfringence dans la fibre optique. On choisit donc le brouilleur ou le contrôleur de polarisation qui change la polarisation du faisceau injecté de telle sorte que l'amplitude des composantes fréquentielles Brillouin soit maximale. Ce brouilleur ou contrôleur de polarisation permet ainsi avantageusement de faciliter la mesure de la ou des propriétés de la fibre étudiée.

Par ailleurs, pour améliorer encore plus la performance du système de mesure, il est également possible d'utiliser également un contrôleur de polarisation, disposé sur le trajet de l'onde de référence, et sélectionné de manière à augmenter la sensibilité du système de mesure en augmentant l'amplitude du battement entre l'onde de référence et l'onde rétroréfléchie.

Dans le deuxième cas, c'est-à-dire lorsque le système de mesure est configuré pour être exploité en mode Brillouin stimulé, le système de mesure est configuré pour projeter l'onde de référence dans la deuxième extrémité de la fibre.

Dans ce deuxième cas comme dans le premier, le système de mesure peut éventuellement être mis en œuvre sans action particulière pour modifier la polarisation de l'onde (ou des ondes) émises par le dispositif d'émission laser.

Cependant, pour améliorer la performance du système de mesure, on peut également agir sur la polarisation à la fois de l'onde incidente et de l'onde de référence, afin d'augmenter l'amplitude des composantes fréquentielles Brillouin dans la fibre optique.

Aussi, dans un mode de réalisation préférentiel le système de mesure comprend en outre deux contrôleurs de polarisation, interposés respectivement sur le trajet de l'onde incidente entre le dispositif d'émission laser et le premier mélangeur optique, et sur le trajet de l'onde de référence entre le dispositif d'émission laser et la deuxième extrémité de la fibre.

Dans ce mode de réalisation, l'amplitude des composantes fréquentielles Brillouin stimulées dans les fibres optiques dépend de l'état de la polarisation relatif local entre les deux faisceaux injectés dans la fibre optique (pompe-sonde). Pour cette raison l'installation de contrôleurs de polarisations pour les deux faisceaux permet d'augmenter l'amplitude des composantes fréquentielles Brillouin et de faciliter la procédure de détection.

L'invention concerne également un capteur de température et/ou de déformation, comprenant au moins un système de mesure tel que décrit précédemment, et au moins une fibre optique à laquelle ledit système est relié, ladite au moins une propriété déterminée par le système comprenant une température et/ou une déformation d'une partie de la fibre.

L'invention concerne également l'utilisation d'un capteur de température et/ou de déformation tel que défini précédemment pour mesurer une température ou une déformation d'un objet sur et/ou dans lequel la fibre optique est disposée. L'objet peut être par exemple un ouvrage d'art, une pièce industrielle, une partie de véhicule (aile d'avion..), etc.

Une ou éventuellement plusieurs fibre optique sont alors disposées en surface et/ou à l'intérieur de l'objet et reliées au système de mesure suivant l'invention.

Grâce à ces fibres optiques placées sur ou dans l'objet considéré, le système de mesure permet alors de mesurer la température et/ou la déformation de celui-ci.

### BREVE DESCRIPTION DES DESSINS

L'invention sera bien comprise et ses avantages apparaîtront mieux à la lecture de la description détaillée qui suit, de modes de réalisation représentés à titre d'exemples non limitatifs. La description se réfère aux dessins annexés, sur lesquels :
- la figure 1 déjà décrite est un diagramme schématique présentant les variations d'intensité, en fonction de la fréquence, d'une onde incidente, de composantes Stokes et anti-Stokes d'une onde rétroréfléchie, et d'une onde de référence ;
- la figure 2 est une vue schématique d'un système de mesure dans un premier mode de réalisation de l'invention, permettant une analyse de rétroréflexion Brillouin du type Brillouin spontané ;
- la figure 3 est une vue schématique d'un système de mesure dans un second mode de réalisation de l'invention, permettant une analyse de rétroréflexion Brillouin du type Brillouin stimulé ; et
- la figure 4 est une vue schématique d'une source laser utilisable dans un système de mesure selon l'invention.

### DESCRIPTION DETAILLEE DE L'INVENTION

### Brillouin spontané

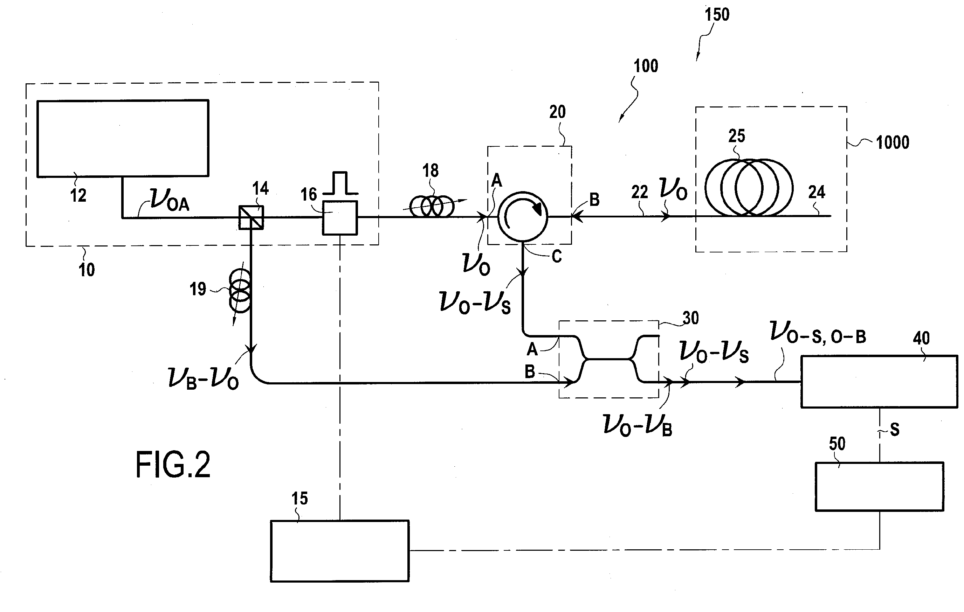

En faisant référence à la figure 2, un système de mesure 100 par analyse de rétroréflexion Brillouin conforme à l'invention va maintenant être présenté. Dans ce mode de réalisation, le système de mesure 100 est fondé sur la rétroréflexion Brillouin spontanée se produisant spontanément dans une fibre 25 à laquelle le système de mesure est relié, en réponse à l'envoi d'une onde incidente ν0.

Le système de mesure 100, associé à la fibre optique 25 constitue un capteur de température et de déformation 150 au sens de l'invention. Dans l'exemple présenté, la fibre 25 est placée à l'intérieur d'un objet 1000; le capteur 150 permet ainsi de mesurer la température et les déformations de l'objet 1000.

Le système de mesure 100 comprend un dispositif d'émission laser 10, un premier mélangeur optique 20, un brouilleur ou contrôleur de polarisation 18 et un contrôleur de polarisation 19 (qui sont optionnels), un deuxième mélangeur optique 30, un détecteur optique 40, un analyseur de fréquence électronique 50, et un système de synchronisation 15.

Dans le système 100, le dispositif d'émission laser 10 est un dispositif servant à produire une onde incidente ν0 et une onde de référence ν0-νB, toutes deux sensiblement monochromatiques (Pour simplifier, les ondes portent le nom de leur composante fréquentielle principale, à savoir dans le cas présent *ν*0 et ν0-νB).

L'écart de fréquence vB entre les deux ondes v0 et v0-vB est égal au décalage de fréquence Brillouin. Ce décalage de fréquence Brillouin a une valeur fixe, qui dépend essentiellement de la longueur d'onde de l'onde incidente. Pour une longueur d'onde de 1,55 µm, le décalage de fréquence Brillouin est de 11 GHz (dans le cas de fibres optiques à base de silice).

Le dispositif d'émission 10 comporte une source laser 12 configurée pour émettre une onde incidente primaire *ν*0A, un cube séparateur de faisceau 14 et un modulateur électro-optique 16.

La source laser 12 est une source laser bi-fréquence à cavité verticale émettant par la surface (VECSEL), qui sera décrite plus loin en relation avec la figure 4.

L'onde incidente primaire ν0A est la superposition de deux ondes de fréquences différentes, à savoir l'onde incidente, de fréquence ν0 (ν0 est la fréquence incidente) et l'onde de référence, de fréquence ν0-νB (ν0-νB est la fréquence de référence). L'onde incidente et l'onde de référence ont des polarisations différentes ; cette propriété est utilisée pour les séparer. Les longueurs d'onde λ de l'onde incidente ν0 et de l'onde de référence ν0-νB sont toutes deux de l'ordre de 1,55 µm.

Pour séparer ces deux ondes, un cube séparateur de faisceau 14 est interposé sur le faisceau de l'onde incidente primaire ν0A. Il sépare ce faisceau en deux faisceaux constituant respectivement l'onde incidente ν0 et l'onde de référence ν0-νB.

Pour permettre de déterminer la distance à laquelle est mesurée la température ou la déformation de la fibre par réflectométrie optique en domaine temporel (OTDR), l'onde incidente ν0 est émise par le dispositif d'émission laser 10 sous forme d'impulsions successives.

Afin de produire ces impulsions, le dispositif d'émission 10 comporte un modulateur électro-optique 16. Ce modulateur électro-optique 16 est configuré pour moduler l'onde incidente ν0 et délivrer celle-ci sous forme d'impulsions successives.

L'onde incidente ainsi produite est transmise tout d'abord au contrôleur ou brouilleur de polarisation 18. Celui-ci est interposé sur le trajet de l'onde incidente entre le dispositif d'émission laser 10 et le premier mélangeur optique 20.

Le contrôleur ou le brouilleur de polarisation 18 sert à modifier l'état de polarisation de l'onde incident et doit être réglé ou sélectionné de manière à augmenter au maximum l'amplitude des composantes fréquentielles Brillouin dans la fibre optique.

De plus, le contrôleur de polarisation 19 est disposé sur le trajet de l'onde de référence pour augmenter la sensibilité du système de mesure.

Le contrôleur de polarisation 19 sert à modifier l'état de polarisation de l'onde de référence. Il est réglé ou sélectionné de manière à optimiser l'efficacité de la détection cohérente réalisée par le détecteur optique 40 et l'analyseur de fréquence électronique 50.

En effet, l'amplitude des composantes fréquentielles Brillouin stimulées dans les fibres optiques dépend de l'état de la polarisation relatif local entre les deux faisceaux injectés dans la fibre optique : lorsque les deux polarisations sont colinéaires l'amplitude des composantes fréquentielles Brillouin est maximale, et par suite la détection des spectres Brillouin est plus facile.

L'onde incidente ν0 mise en forme est transmise à une première entrée A du premier mélangeur 20. Le premier mélangeur 20 transmet cette onde jusqu'à une deuxième entrée B du premier mélangeur 20, qui est reliée à une première extrémité 22 de la fibre optique 25 que l'on souhaite tester. Une partie de l'onde incidente ν0 est donc ainsi transmise dans la fibre optique 25.

La deuxième extrémité de la fibre optique 25 est notée 24.

A la première extrémité 22 de la fibre optique 25, le premier mélangeur 20 collecte en retour, dans sa deuxième entrée B, l'onde rétroréfléchie par la fibre optique.

Cette onde rétroréfléchie comporte différentes composantes fréquentielles. Elle comporte notamment les deux composantes fréquentielles spécifiques Stokes et anti-Stokes du spectre Brillouin. Ces composantes sont décalées, par rapport à la fréquence de l'onde incidente ν0, respectivement de + vS et -vS. La valeur exacte de ce décalage est fonction de la température de la fibre 25, ainsi que des déformations de celles-ci, et éventuellement d'autres paramètres.

Dans le système 100, la température et/ou la déformation de la fibre est mesurée par analyse de la composante 'anti-Stokes' de l'onde rétroréfléchie. Pour cette raison l'onde rétroréfléchie est notée v0-vS (conventionnellement, puisqu'elle comporte d'autres fréquences que la fréquence v0-vS, notamment la fréquence v0+vS).

L'onde rétroréfléchie v0-vS est collectée par le premier mélangeur 20 et transmise via une sortie C de celui-ci à une première entrée A du deuxième mélangeur 30.

L'onde de référence v0-vB est par ailleurs transmise à une deuxième entrée B du deuxième mélangeur 30.

Le deuxième mélangeur 30 produit alors en sortie une onde composite référencée v0-S,0-B dans laquelle l'onde rétroréfléchie v0-vS et l'onde de référence v0-vB sont combinées et superposées.

L'onde composite v0-S,0-B présente un battement du fait de l'interférence entre l'onde rétroréfléchie v0-vS et l'onde de référence v0-vB.

L'onde composite v0-S,0-B produite par le deuxième mélangeur 30 est transmise à un récepteur optique 40. Celui-ci, qui peut être par exemple une photodiode, convertit l'onde lumineuse qu'il reçoit en un signal électronique S dont la fréquence est la fréquence de battement du signal optique qu'il reçoit.

Ce signal électronique est transmis à un analyseur de fréquences électronique 50. Celui-ci détermine une information cherchée relative à la fibre optique, à partir de la fréquence de la composante anti-Stokes présente dans l'onde composite transmise au récepteur optique 40 et par suite, présente dans le signal électronique transmis par celui-ci à l'analyseur de fréquence 50.

L'analyseur 50 est typiquement un oscilloscope. Celui-ci est synchronisé sur la période des impulsions du signal électronique, afin de présenter visuellement les variations d'intensité de celle-ci.

L'analyse de l'onde composite ν0-S,0-B (via le signal S) permet de localiser spatialement les événements affectant la fibre optique 25 testée. On a ainsi la possibilité de quantifier les déformations et/ou les hausses de température affectant la fibre 25.

En outre, la synchronisation des impulsions produites par le modulateur 16 est assurée par le système de synchronisation 15. Dans ce but, celui-ci est connecté à l'analyseur de fréquences 50. A partir des informations de l'analyseur 50, il transmet des signaux de commande au modulateur 16 afin de réguler le fonctionnement de celui-ci.

L'analyseur de fréquences 50 peut comporter un convertisseur fréquence/tension, qui convertit la fréquence en une tension proportionnelle, et un ordinateur de traitement de signal, qui détermine une température et/ou une déformation de la fibre à partir de la tension produite par le convertisseur.

L'ordinateur utilisé pour le traitement du signal peut alors être utilisé pour piloter le système de synchronisation 15, qui contrôle l'émission des impulsions laser émises par le modulateur 16.

Le premier mélangeur 20 et/ou le deuxième mélangeur 30 peut être un coupleur de fibres optiques ou un circulateur optique.

### Brillouin stimulé

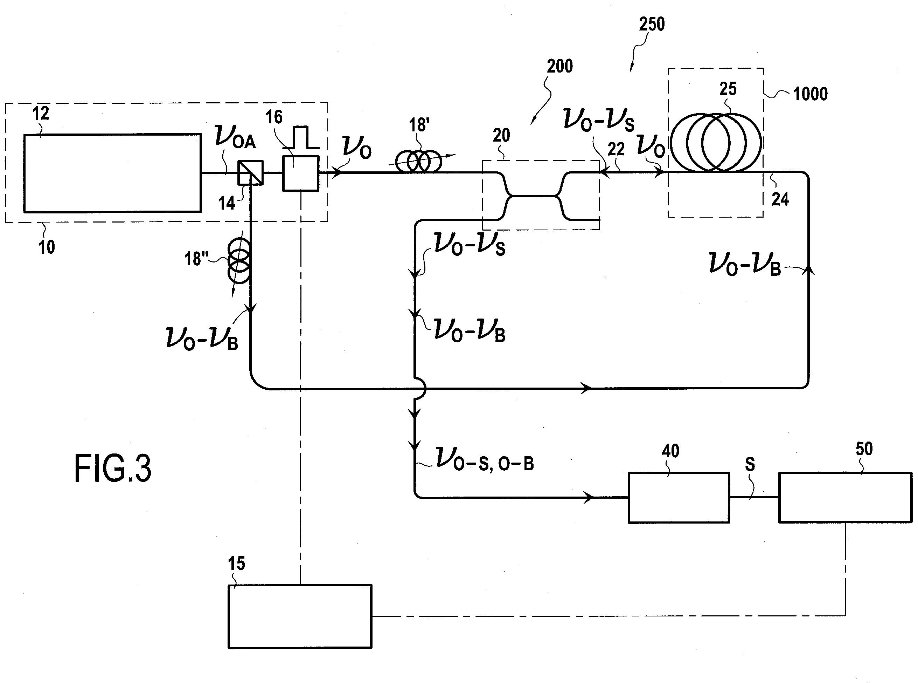

En faisant référence à la figure 3, un système de mesure 200 par analyse de rétroréflexion Brillouin correspondant à un second mode de réalisation de l'invention va maintenant être présenté.

Ce système de mesure 200 est fondé sur la rétroréflexion Brillouin stimulée, qui se produit dans la fibre en réponse à l'envoi d'une onde incidente, mais alors que la fibre sert déjà à la transmission de l'onde de référence ν0-νB, l'onde de référence ν0-νB étant projetée dans la fibre dans le sens opposé au sens de projection de l'onde incidente ν0 dans la fibre.

Le système de mesure 200 associé à la fibre optique 25 constitue un capteur de température et de déformation 250 au sens de l'invention.

Sauf indication contraire, le système de mesure 200 et le capteur de température et de déformation 250 sont identiques respectivement au système de mesure 100 et au capteur de température et de déformation 150.

Aussi, les éléments du système de mesure 200 ayant une structure ou une fonction identique ou analogue aux éléments correspondants du système de mesure 100 portent la même référence numérique que ceux-ci.

Le système de mesure 200 comprend un dispositif d'émission laser 10, deux contrôleurs de polarisation 18' et 18" (qui sont optionnels), un premier mélangeur optique 20, un détecteur optique 40, un analyseur de fréquence électronique 50, et un système de synchronisation 15.

Sauf indication contraire, ces composants sont identiques à ceux du dispositif 100.

Les contrôleurs de polarisation 18' et 18" sont interposés d'une part, sur le trajet de l'onde incidente entre le dispositif d'émission laser 10 et le premier mélangeur optique 20, et d'autre part, sur le trajet de l'onde de référence, entre le dispositif d'émission laser 10 et la deuxième entrée 24 de la fibre optique 25.

Les contrôleurs de polarisation 18' et 18" servent à modifier les états de polarisation des deux ondes (onde incidente et onde de référence) et doivent être sélectionnés ou réglés de manière à maximiser l'amplitude des composantes fréquentielles Brillouin stimulées dans la fibre optique.

Pour illustrer le fait que le premier mélangeur optique 20 peut être soit un circulateur soit un coupleur, on a représenté le premier mélangeur optique 20 dans la figure 2 sous forme de circulateur, alors que dans la figure 3, on l'a représenté sous forme de coupleur.

Le système de mesure 200 ne comporte pas de deuxième mélangeur 30 car la superposition de l'onde rétroréfléchie ν0-νS et de l'onde de référence ν0-νB se fait directement dans la fibre 25.

En effet, dans ce mode de réalisation l'onde de référence ν0-νB est injectée dans la deuxième extrémité 24 de la fibre 25, au lieu d'être injectée dans l'une des entrées d'un deuxième mélangeur optique (référencé 30 dans le système de mesure 100, et inexistant dans le système 200).

Par suite, à la première extrémité 22 de la fibre optique 25, l'onde émise par la fibre est la superposition de l'onde rétroréfléchie v0-vS et de l'onde de référence v0-vB : cette onde constitue donc l'onde composite v0-S,0-B décrite en relation avec le système de mesure 100 décrit précédemment. Comme dans le système de mesure 100, cette onde composite v0-S,0-B est transmise au détecteur optique 40 pour analyse.

L'analyse du spectre Brillouin de l'onde composite v0-S,0-B permet de déterminer les propriétés cherchées de la fibre à savoir sa déformation et sa température.

Avantageusement, le recours à la réflectométrie optique en domaine temporel (qui est un perfectionnement optionnel de l'invention) permet de déterminer la position sur la fibre 25 à laquelle correspondent les informations de déformation et de température ainsi déterminées.

En faisant référence à la figure 4, la source laser 12 utilisée dans les modes de réalisation présentés précédemment va maintenant être présentée.

Cette source est une source laser de type 'VECSEL', c'est-à-dire une source composée par un semiconducteur en cavité externe à émission par la surface (VECSEL : vertical-external-cavity surface-emitting-laser). La caractéristique spécifique de cette source est qu'elle permet d'émettre en sortie une onde constituée principalement par la superposition de deux ondes séparées en fréquence et polarisées orthogonalement. Dans le cas présent, le décalage de fréquence est d'environ 11GHz.

La source 12 comporte une structure semiconducteur active 12A, dont la température est contrôlée au moyen d'un dispositif Peltier 12B.

Le pompage optique est assuré par une source laser 12C.

La structure semiconducteur 12A est dimensionnée pour émettre une onde ayant une longueur d'onde égale à 1,55 µm.

La cavité optique 12D de la source laser 12 est aménagée entre la structure active 12A et un miroir diélectrique concave 12E.

À l'intérieur de la cavité optique 12D, deux éléments sont installés :
- une lame biréfringente 12F. Cette lame 12F induit une différence de chemin optique ainsi qu'une séparation spatiale des deux ondes de polarisations orthogonales, qui favorisent l'émission bifréquence et bipolarisée (onde ordinaire 'o', et extraordinaire 'e') en réduisant le couplage entre les deux modes. La lame 12F peut être une lame biréfringente de vanadate d'yttrium (YVO₄).
- un étalon Fabry-Pérot 12G (constitué d'une lame de silice) : Il assure un fonctionnement laser monofréquence stable sur chaque polarisation, autour de la longueur d'onde ciblée (1,55 µm dans le mode de réalisation présenté).

Les deux ondes partagent la même cavité laser, et sont soumises aux mêmes fluctuations thermiques et mécaniques, ce qui assure leur très grande cohérence, et permet d'avoir un hétérodynage optique très efficace.

La longueur totale de la cavité est fixée de manière à assurer un intervalle spectral libre supérieur à 13 GHz.

Le système laser a une sortie fibrée, c'est-à-dire que la sortie du laser est injectée dans une fibre optique.

Quoique la présente invention ait été décrite en se référant à des exemples de réalisation spécifiques, il est évident que des différentes modifications et changements peuvent être effectués sur ces exemples sans sortir de la portée générale de l'invention telle que définie par les revendications. En outre, des caractéristiques individuelles des différents modes de réalisation évoqués peuvent être combinées dans des modes de réalisation additionnels.

Par ailleurs, il existe plusieurs techniques voisines qui servent à mesurer le spectre Brillouin : B-OTDR (pour Brillouin OTDR), Brillouin Optical Time Domain Analyzer (B-OTDA), Brillouin Optical Coherent Domain Analyzer (B-OCDA), Brillouin Optical Frequency Domain Analyzer (B-OFDA), etc. Toutes ces techniques sont dérivées de la technique de réflectométrie optique en domaine temporel (OTDR) décrite précédemment. L'invention peut être mise en œuvre quelle que soit celle de ces techniques qui est utilisée. Par conséquent, la description et les dessins doivent être considérés dans un sens illustratif plutôt que restrictif.

## Revendications

1. Système de mesure par analyse de rétroréflexion Brillouin, comprenant un dispositif d'émission laser (10) configuré pour émettre une onde incidente (v0) et une onde de référence (v0-vB), l'onde incidente présentant une fréquence incidente (v0) et l'onde de référence présentant une fréquence de référence (v0-vB), la fréquence de référence (v0-vB) étant décalée de la fréquence incidente (v0) d'une valeur prédéterminée (vB),
le système étant configuré pour, lorsqu'il est connecté à au moins une première extrémité (22) d'une fibre optique (25) ;
- projeter l'onde incidente (v0) dans ladite première extrémité (22) de la fibre (25) ;
- recevoir en retour, à la première extrémité de la fibre, une onde rétroréfléchie (ν0-νS);
- générer une onde composite (v0-S,0-B) combinant au moins l'onde rétroréfléchie (v0-vS) et l'onde de référence (v0-vB) ;
- déterminer au moins une propriété relative à la fibre par analyse d'un spectre Brillouin de l'onde composite (v0-S,0-B) ;
le système **se caractérisant en ce que** l'onde incidente et l'onde de référence proviennent d'une source laser (12) bi-fréquence à cavité verticale émettant par la surface faisant partie du dispositif d'émission laser (10).

2. Système de mesure selon la revendication 1, dans lequel la longueur d'onde de l'onde incidente (v0) est comprise entre 1,3 µm et 1,8 µm.

3. Système de mesure selon la revendication 1 ou 2, comprenant un détecteur optique (40) disposé sur le trajet de l'onde composite de manière à collecter l'onde composite, et un analyseur de fréquence (50) configuré pour analyser le spectre Brillouin de l'onde composite de manière à déterminer ladite au moins une propriété relative à la fibre.

4. Système de mesure selon l'une quelconque des revendications 1 à 3, comprenant un premier mélangeur optique (20) configuré pour être placé sur le trajet de l'onde incidente (v0) entre le dispositif d'émission laser (10) et la première extrémité (22) de la fibre optique (25).

5. Système de mesure selon la revendication 4, dont le premier mélangeur optique (20) est un circulateur optique ou un coupleur de fibres optiques.

6. Système de mesure selon l'une quelconque des revendications 1 à 5, configuré pour projeter une onde uniquement à la première extrémité (22) de la fibre.

7. Système de mesure selon la revendication 4 ou 5, configuré pour projeter une onde dans la fibre uniquement à la première extrémité (22) de celle-ci, et comprenant en outre un deuxième mélangeur optique (20) configuré pour recevoir en entrée respectivement l'onde composite et l'onde de référence, et fournir en sortie un signal constitué en superposant ces deux ondes.

8. Système de mesure selon la revendication 4 ou 5, configuré pour projeter une onde uniquement à la première extrémité (22) de la fibre, et comprenant en outre un contrôleur de polarisation ou un brouilleur de polarisation (18), interposé entre le dispositif d'émission laser (10) et le premier mélangeur optique (20).

9. Système de mesure selon l'une quelconque des revendications 1 à 5, configuré en outre pour projeter également une onde (v0-vB) à la deuxième extrémité (24) de la fibre.

10. Système de mesure selon la revendication 9, comprenant en outre deux contrôleurs de polarisation (18',18"), interposés respectivement sur le trajet de l'onde incidente (v0) entre le dispositif d'émission laser (10) et le premier mélangeur optique (20), et sur le trajet de l'onde de référence (v0-vB) entre le dispositif d'émission laser (10) et la deuxième extrémité (24) de la fibre.

11. Capteur de température et/ou de déformation, comprenant au moins un système de mesure (100) selon l'une quelconque des revendications 1 à 10, et au moins une fibre optique (25) à laquelle ledit système est relié, ladite au moins une propriété déterminée par le système comprenant une température et/ou une déformation d'une partie de la fibre.

12. Utilisation d'un capteur de température et/ou de déformation selon la revendication 11 pour mesurer une température ou une déformation d'un objet (1000) sur et/ou dans lequel la fibre optique (25) est disposée.

## Patentansprüche

1. System zur Messung durch Analyse von Brillouin-Retroreflexion, das eine Laser-Emissionsvorrichtung (10) umfasst, die dazu ausgestaltet ist, eine einfallende Welle (v0) und eine Bezugswelle (v0 - vB) zu emittieren, wobei die einfallende Welle eine Einfallsfrequenz (v0) aufweist und die Bezugswelle eine Bezugsfrequenz (v0 - vB) aufweist, wobei die Bezugsfrequenz (v0 - vB) um einen vorbestimmten Wert (vB) von der Einfallsfrequenz (v0) versetzt ist,
wobei das System, wenn es mit mindestens einem ersten Ende (22) einer optischen Faser (25) verbunden ist, ausgestaltet ist zum:
- Projizieren der einfallenden Welle (v0) in das erste Ende (22) der Faser (25),
- im Gegenzug dazu, Empfangen einer retroreflektierten Welle (v0 - vS) an dem ersten Ende der Faser,
- Erzeugen einer zusammengesetzten Welle (v0 - S, 0 - B), die mindestens die retroreflektierte Welle (v0 - vS) und die Bezugswelle (v0 - vB) kombiniert,
- Bestimmen von mindestens einer Eigenschaft, die die Faser betrifft, durch Analyse eines Brillouin-Spektrums der zusammengesetzten Welle (v0 - S, 0 - B),
wobei das System **dadurch gekennzeichnet ist, dass** die einfallende Welle und die Bezugswelle von einer Zweifrequenz-Laserquelle (12) mit vertikalem Hohlraum stammen, die über die Oberfläche emittiert, die Teil der Laser-Emissionsvorrichtung (10) ist.

2. Messsystem nach Anspruch 1, wobei die Wellenlänge der einfallenden Welle (v0) zwischen 1,3 µm und 1,8 µm liegt.

3. Messsystem nach Anspruch 1 oder 2, das einen optischen Detektor (40), der auf dem Weg der zusammengesetzten Welle derart angeordnet ist, dass die zusammengesetzte Welle erfasst wird, und einen Frequenzanalysator (50) umfasst, der dazu ausgestaltet ist, das Brillouin-Spektrum der zusammengesetzten Welle derart zu analysieren, dass die mindestens eine Eigenschaft, die die Faser betrifft, bestimmt wird.

4. Messsystem nach einem der Ansprüche 1 bis 3, das einen ersten optischen Mischer (20) umfasst, der dazu ausgestaltet ist, auf dem Weg der einfallenden Welle (v0) zwischen der Laser-Emissionsvorrichtung (10) und dem ersten Ende (22) der optischen Faser (25) platziert zu sein.

5. Messsystem nach Anspruch 4, dessen erster optischer Mischer (20) ein optischer Zirkulator oder ein optischer Faserkoppler ist.

6. Messsystem nach einem der Ansprüche 1 bis 5, das dazu ausgestaltet ist, eine Welle nur an dem ersten Ende (22) der Faser zu projizieren.

7. Messsystem nach Anspruch 4 oder 5, das dazu ausgestaltet ist, eine Welle in die Faser nur an deren erstem Ende (22) zu projizieren, und ferner einen zweiten optischen Mischer (20) umfasst, der dazu ausgestaltet ist, als Eingang jeweils die zusammengesetzte Welle und die Bezugswelle zu empfangen und als Ausgang ein Signal zu liefern, das durch Überlagern dieser zwei Wellen gebildet wird.

8. Messsystem nach Anspruch 4 oder 5, das dazu ausgestaltet ist, eine Welle nur an dem ersten Ende (22) der Faser zu projizieren, und ferner eine Polarisationssteuereinrichtung und einen Polarisations-Scrambler (18) umfasst, der zwischen der Laser-Emissionsvorrichtung (10) und dem ersten optischen Mischer (20) angeordnet ist.

9. Messsystem nach einem der Ansprüche 1 bis 5, das ferner dazu ausgestaltet ist, auch eine Welle (v0 - vB) an dem zweiten Ende (24) der Faser zu projizieren.

10. Messsystem nach Anspruch 9, das ferner zwei Polarisationssteuereinrichtungen (18', 18") umfasst, die jeweils auf dem Weg der einfallenden Welle (v0) zwischen der Laser-Emissionsvorrichtung (10) und dem ersten optischen Mischer (20) und auf dem Weg der Bezugswelle (v0 - vB) zwischen der Laser-Emissionsvorrichtung (10) und dem zweiten Ende (24) der Faser angeordnet sind.

11. Temperatur- und/oder Verformungssensor, der mindestens ein Messsystem (100) nach einem der Ansprüche 1 bis 10 und mindestens eine optische Faser (25) umfasst, mit der das System verbunden ist, wobei die mindestens eine durch das System bestimmte Eigenschaft eine Temperatur und/oder eine Verformung eines Teils der Faser umfasst.

12. Verwendung eines Temperatur- und/oder Verformungssensors nach Anspruch 11 zum Messen einer Temperatur oder einer Verformung eines Gegenstands (1000), auf und/oder in dem die optische Faser (25) angeordnet ist.

## Claims

1. A measurement system for performing measurement by Brillouin scattering analysis, the system comprising a laser emitter device (10) configured to emit an incident wave (v0) and a reference wave (v0-vB), the incident wave presenting an incident frequency (v0) and the reference wave presenting a reference frequency (v0-vB), the reference frequency (v0-vB) being shifted from the incident frequency (v0) by a predetermined value (vB), the system being configured, when it is connected to at least a first end (22) of an optical fiber (25):
- to project the incident wave (v0) into said first end (22) of the fiber (25);
- to receive in return a backscattered wave (ν0-νS) at the first end of the fiber;
- to generate a composite wave (ν0-S, 0-B) combining at least the backscattered wave (ν0-νS) and the reference wave (ν0-νB);
- to determine at least one property relating to the fiber by analyzing a Brillouin spectrum of the composite wave (ν0-S, 0-B);
the system being **characterized in that** the incident wave and the reference wave come from a dual-frequency vertical-cavity surface-emitting laser source (12) forming part of the laser emitter device (10).

2. A measurement system according to claim 1, wherein the wavelength of the incident wave (v0) lies in the range 1.3 µm to 1.8 µm.

3. A measurement system according to claim 1 or claim 2, including an optical detector (40) arranged on the path of the composite wave so as to collect the composite wave, and a frequency analyzer (50) configured to analyze the Brillouin spectrum of the composite wave so as to determine said at least one property relating to the fiber.

4. A measurement system according to any one of claims 1 to 3, including a first optical mixer (20) configured to be placed on the path of the incident wave (v0) between the laser emitter device (10) and the first end (22) of the optical fiber (25).

5. A measurement system according to claim 4, wherein the first optical mixer (20) is an optical circulator or an optical fiber coupler.

6. A measurement system according to any one of claims 1 to 5, configured to project a wave solely into the first end (22) of the fiber.

7. A measurement system according to claim 4 or claim 5, configured to project a wave into the fiber only at the first end (22) thereof, and further including a second optical mixer (20) configured to receive as input respectively the composite wave and the reference wave, and to deliver as output a signal constituted by superposing those two waves.

8. A measurement system according to claim 4 or claim 5, configured to project a wave solely into the first end (22) of the fiber, and further comprising a polarization controller or polarization scrambler (18) interposed between the laser emitter device (10) and the first optical mixer (20).

9. A measurement system according to any one of claims 1 to 5, further configured also to project a wave (v0-vB) into the second end (24) of the fiber.

10. A measurement system according to claim 9, further comprising two polarization controllers (18', 18") interposed respectively on the path of the incident wave (v0) between the laser emitter device (10) and the first optical mixer (20), and on the path of the reference wave (v0-vB) between the laser emitter device (10) and the second end (24) of the fiber.

11. A temperature and/or deformation sensor comprising at least one measurement system (100) according to any one of claims 1 to 10, and at least one optical fiber (25) to which said system is connected, said at least one property determined by the system comprising a temperature and/or a deformation of a portion of the fiber.

12. The use of a temperature and/or deformation sensor according to claim 11 for measuring a temperature or a deformation of a structure (1000) on and/or in which the optical fiber (25) is arranged.
